Europäisches Patentamt

European Patent Office

Office européen des brevets

(11) Publication number:

**0 356 757**
**A2**

## (12) EUROPEAN PATENT APPLICATION

(21) Application number: **89114436.2**

(22) Date of filing: **04.08.89**

(51) Int. Cl.5: **H01R 27/00 , G06F 13/40**

(30) Priority: **02.09.88 BE 8801008**

(43) Date of publication of application:
**07.03.90 Bulletin 90/10**

(84) Designated Contracting States:
**BE CH DE FR GB IT LI LU**

(71) Applicant: **DEVLONICS TERMINALS N.V.**
**Stasegemsesteenweg 110**
**B-8500 Kortrijk(BE)**

(72) Inventor: **Ghekiere, Dirk**
**Zwevegemsestraat 70**
**B-8562 Otegem(BE)**

(74) Representative: **Dopchie, Jean-Marc**
**KORTRIJKS OCTROOI- EN MERKENBUREAU -**
**K.O.B. Kennedypark 21c**
**B-8500 Kortrijk(BE)**

(54) Computer expansion board suitable for two types of computers.

(57) Computer expansion board comprising two coupling pieces (2, 3) which are each suitable for coupling to a mating coupling piece of a computer of one type, associated with the board coupling piece, of two types, a processing circuit, and switching means which are suitable for transmitting signals between a group of connection segments (4, 5) of the one or the other board coupling piece and the processing circuit, depending on the type of computer connected to the board.

Fig 1

EP 0 356 757 A2

## Computer expansion board suitable for two types of computers

The invention relates to a computer expansion board comprising a coupling piece which is suitable for coupling to a mating coupling piece of a computer to obtain an electrical connection between conductors connected to the computer coupling piece and connection segments of the board coupling piece, board conductors connected to connection segments of the board coupling piece being connected to components, mounted on the board, of a processing circuit.

Computer expansion boards of this type are known from practice and are very often used. The board may have various types of processing circuits and functions, such as, for example, a memory, analog/digital converter, digital/analog converter, modem, etc. Because the coupling pieces of different types of computers often have different arrangements or connections thereof fulfil, different functions, various versions of boards having processing circuits of a particular type are necessary in addition, for different types of computers. As a result of this, manufacturers and suppliers of each type of board have to hold in stock various versions with different coupling pieces in order to be able to satisfy any demand for a particular board having a particular coupling piece. This forms an important drawback because such a stock, in which two or more versions of each board have to be held in stock, is very expensive and extensive.

.The object of the invention is to eliminate the drawback described above.

This object is achieved, according to the invention, for a computer expansion board of the type mentioned in the preamble in that the board comprises a first board coupling piece and a second board coupling piece which are suitable for connecting the board to a computer of a first or a second type respectively, and in that the board comprises switching means which are suitable for transmitting signals between a group of connection segments of the one or of the other board coupling piece and the processing circuit, depending on the type of computer connected to the board.

A number of connection segments having the same functions, for example the data conductors, may generally be connected directly to one another and to the processi circuit. When a computer is connected to the associated board coupling piece, the connection segments of the other board coupling piece do not receive a signal, with the result that said connection segments of the other board coupling piece do not have any influence on the satisfactory operation of the processing circuit for the computer connected to the one board coupling piece. In practice, for example for an IBM XT/AT PC computer as first type of computer and an IBM PSII computer as second type of computer (and compatible computers), it is often adequate to connect the address lines, with the exception of a particular group of least significant address lines, of the two address buses to the processing circuit via the switching means. As a result of this, the computer expansion board is made suitable in an inexpensive manner for use with two different types of computers by adding very few components. As a result of this, it will be possible to reduce, the stock of such boards reduced and the cost of holding such a stock is significantly lower.

In general it is the case that if a section of corresponding signals from the different board coupling pieces are differently processed, for example for component selection ("chip select") in the example given above, the processed signals are transmitted via the switching means to the common processing circuit for the different types of computers.

According to one characteristic of the invention, it is the case that the switching means comprise a switch element to be actuated by the user to set the switching means therewith in accordance with the type of computer connected to the board. As a result of this a simple embodiment of the switching means is obtained which, however, during installation of the expansion board in the computer concerned, requires the user to attend to setting the switch element in accordance with the type of computer.

According to another feature of the invention, it is the case that the switching means comprise a detection conductor which is suitable for connection to a point in a computer of the first type, said point having a potential which is characteristic of the first type of computer, and that the switching means switch in accordance with the potential present on the detection conductor. According to a particular embodiment, the connection of the point in the computer with the detection conductor is brought about without additional operations by the user during the installation of the board in the computer of the first type. As a result of this no error can be made in setting the switching means when installing the board.

The detection conductor may comprise, as for the IBM computers named, a metal cover plate fixed to the board.

It is preferable, in particular in the case of the IBM computers, that the coupling pieces are fitted symmetrically with respect to a diagonal of the board. As a result of this the periphery of the board will not alter with respect to the computers in which the board is mounted and the components of the board will always be situated on the same side.

The invention is explained with reference to the drawing. In the drawing:

Figure 1 shows diagramatically a computer expansion board according to the invention in perspective;

Figure 2 shows a diagram of a circuit mounted on the board shown in Figure 1.

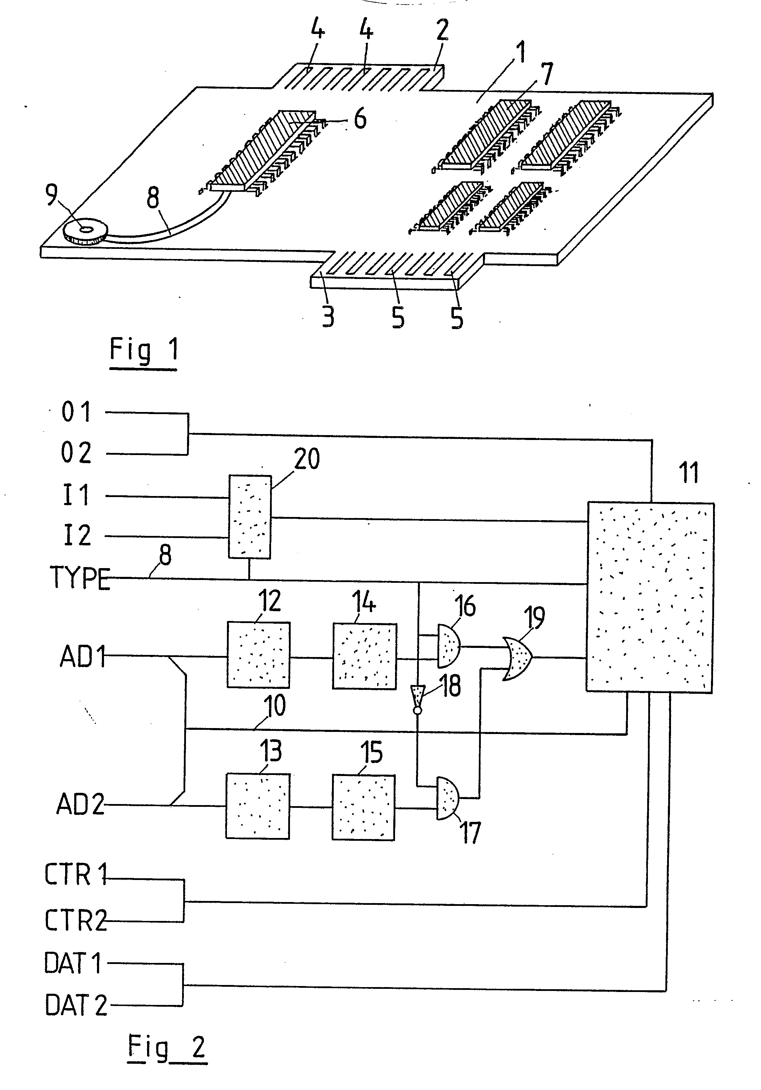

Figure 1 shows a computer expansion board (1) having a board coupling piece (2) which is suitable for connection to a mating coupling piece of a computer of a first type, and a second board coupling piece (3) which is suitable for connection to a mating coupling piece of a computer of a second type. On one side or on both sides of the board (1), the board coupling pieces (2, 3) each have a number of connection segments or connection areas (4) and (5) respectively, which are connected to components, such as (6, 7), of a circuit mounted on the board (1) by means of board (1) conductors which are not shown. A number of the connection areas (4) of the first board coupling piece (2) may be connected to connection areas (5) of the second board coupling piece (3), as explained below with reference to Figure 2.

The embodiment shown of the board (1) comprises a detection conductor (8) which has a connection segment (9) and which is connected to switching means which are represented here by the component (6). The connection segment (9) is suitable for connection, after the board (1) has been installed in a computer, to a point in the computer which has a potential characteristic of the type of the computer, at least for one of the computers. The board (1) may comprise, for example for the IBM XT/AT and PSII computers (and compatible computers), as first and second type of computers respectively, a metal cover plate which is connected to the connection area (9) and which, on installation in a computer of the first type, comes into contact with a point in the computer having a high potential and which, on installation in a computer of the second type, comes into contact with a point in the computer having earth potential. Depending on whether the board is installed in a first or second type of computer, the potential of the detection conductor (8) consequently corresponds to a logical "1" or "0" level respectively. Depending on the level of the detection conductor (8), the switching means are then able to decide in favour of connection of particular groups of connections surfaces (4) and (5) to the common processing circuits via any individual processing circuits present for these groups.

Figure 2 shows an example of a circuit which may be mounted on the board (1) shown in Figure 1.

The coupling pieces (2, 3) comprise connection surfaces (4) and (5) respectively for an address bus AD1 and AD2 respectively, a data bus DAT 1 and DAT 2 respectively, and a control bus CTR1 and CTR2 respectively, input connections (for example for serial data and/or interruption) I1 and I2 respectively and output connections (for example for serial data) 01 and 02 respectively.

The detection connector (8) has the identification word TYPE in Figure 2.

As shown in Figure 2, the buses CRT1 and CRT2 are connected to one another, the buses DAT 1 and DAT 2 are connected to one another, the output conductors 01 and 02 are connected to one another and a number of conductors, for example three, of the buses AD1 and AD2 are connected to one another. The address bus conductors connected to one another are indicated in Figure 2 by the reference numeral (10).

The circuit in Figure 2 comprises a processing circuit (11) or at least the section of the circuit mounted on the board (1) which is common to each of the two types of computers. The processing circuit (11) is, for example, a modem for receiving serial data from the conductor groups I1 and I2 respectively, for delivering serial data via the conductor groups 01 and 02 respectively and for receiving and delivering parallel data over the data buses DAT 1 and DAT 2 respectively. The control buses CTR1 and CTR2 and the conductor groups I1 and I2 are used to control the processing circuit (11) by means of a computer connected to the board (1).

The sections of the address buses AD1 and AD2 without the common section (11) thereof are connected to a first decoder circuit (12) and a second decoder circuit (13) respectively. The outputs of the decoder circuits (12) and (13) are connected to a first selection circuit (14) and a second selection circuit (15) respectively. By means of the decoder circuits (12) and (13) and the selection circuits (14) and (15), an address of the respective address buses AD1 and AD2 can be selected for which the computer connected to the board (1) wishes to address the processing circuit (11).

Because the connection areas of a non-common section of an address bus AD1, AD2 of a board coupling piece (2) or (3) which is not connected to a computer are electrically floating and may consequently deliver signals with abitary levels to the relevant decoder circuit (12) or (13) respectively as a consequence of parasitic effects, a choice has to be made between the output signal of the selection circuit (14) or (15) depending on which board coupling piece (2, 3) is connected to the computer. The output of the selection circuit (14) is consequently connected to an input of a first AND gates (16), another input of which is connected to the detection conductor (8), and the ouput of the selection circuit (15) is connected to an input of a second AND gate (17), another input of which is connected to the detection conductor (8) via an inverter (18), and the outputs of the AND gates (16) and (17) are connected via an OR gate (19) to a component selection input ("chip select") of the processing circuit (11). If the expansion board (1) is connected to a computer of the first type or of a second type, the output signal of the selection circuit (14) or the output signal of the selection circuit (15) will be transmitted to the selection input of the processing circuit (11).

In the embodiment shown in Figure 2, the input conductors I1 and I2 are connected to an input of the processing circuit (11) via a suitable switching circuit (20) which may comprise a gate configuration such as the gates (16) to (19) inclusive.

In the embodiment shown in Figure 2, the detection conductor (8) is also connected to an input of the processing circuit (11). As a result of this, particular functions of the processing circuit (11), for example a processing speed, can be matched to the type of computer connected.

It is pointed out that, instead of a metal cover plate to be connected to the connection area (9) of the detection conductor (8), use may be made of a switch which can be connected by the user to a high or low potential as required.

It is also pointed out that the switching means, which may comprise a gate configuration such as the combination of the gates (16) to (19) inclusive, may be realised as a function of the common components already available on the board (1), for example of the circuit (11) and of individual components for the different board coupling pieces (2, 3), for example of the circuits (12) to (15) inclusive, sections of which components may be unused without using the invention.

## Claims

1. Computer expansion board comprising a coupling piece (2 or 3) which is suitable for coupling to a mating coupling piece of a computer to obtain an electrical connection between conductors connected to the computer coupling piece and connection segments of the board coupling piece, board conductors connected to connection segments of the board coupling piece being connected to components (6, 7), mounted on the board, of a processing circuit, characterised in that the board comprises a first board coupling piece (2) or (3) and a second board coupling piece (3) or (2) respectively which are suitable for connecting the board to a computer of a first or second type respectively, and in that the board comprises switching means which are suitable for transmitting signals between a group of connection segments (4, 5) of the one or of the other board coupling piece and the processing circuit, depending on the type of computer connected to the board.

2. Board according to Claim 1, characterised in that the switching means comprise a switch element to be actuated by the user to set the switching means therewith in accordance with the type of computer connected to the board.

3. Board according to Claim 1, characterised in that the switching means comprise a detection conductor (8) which is suitable for connection to a point in a computer of the first type, said point having a potential characteristic of the first type of computer, and in that the switching means switch in accordance with the potential present on the detection conductor.

4. Board according to Claim 3, characterised in that the detection conductor (8) comprises a metal cover plate fixed to the board.

5. Board according to Claim 1, having an essentially rectangular shape, characterised in that the coupling pieces (2, 3) are fitted symmetrically with respect to a diagonal of the board.

Fig 1

Fig 2